# EUROPEAN PATENT APPLICATION

(11) **EP 3 872 875 A1**
(43) Date of publication of application: **01.09.2021**
(21) Application number: 19875983.9
(22) Date of filing: 16.10.2019
(51) Int. Cl.: H01L 33/62, H01B 5/02, H01L 23/02, H01L 23/04, H01L 23/08, H01L 23/28, H01L 33/48

(54) **BUS BAR ASSEMBLY AND MANUFACTURING METHOD THEREFOR**

(30) Priority: 23.10.2018 JP 2018199259
(71) Applicant: Suncall Corporation, Kyoto-shi, Kyoto 615-8555 (JP)
(72) Inventor: ADACHI, Yuusuke, kyoto-shi, Kyoto 615-8555 (JP)
(74) Representative: Isarpatent
(86) International application number: PCT/JP2019/040552
(87) International publication number: WO 2020/085154

(57) **Abstract**

A busbar assembly (1, 2A-2G) of this invention includes a plurality of busbars disposed in a common plane with a gap (19) being provided therebetween; and an insulating resin layer having a connecting portion filled in the gap to connect the plurality of busbars (10a, 10b) while electrically insulating them and a peripheral wall portion (35) arranged on a first end surface (21) of a busbar connecting body (20) in which the plurality of busbars (10a, 10b) are connected to one another by the connecting portion (31), wherein the peripheral wall portion (35) is arranged at a peripheral area of the first end surface (21) of the busbar connecting body (20) so that a busbar exposed region (25) at which the first end surfaces (11) of the plurality of busbars (10a, 10b) are exposed is formed at a center of the busbar connecting body (20) in plain view.

## Description

### FIELD OF THE INVENTION

The present invention relates to a busbar assembly in which a plurality of busbars are electrically insulated and mechanically connected to one another, and a method for manufacturing the same.

### BACKGROUND ART

Busbar assemblies in which a plurality of busbars are mutually electrically insulated and mechanically connected are proposed, and are used in various fields (see Patent Literatures 1 and 2 below).

For example, there are proposed laminated-type busbar assemblies in which a first flat plate busbar and a second flat plate busbar in parallel with each other are vertically laminated (see Patent Literatures 1 and 2 below).

However, since, in the laminated-type busbar assembly, the entirety of the opposing flat surface of the first flat plate busbar and the entirety of the opposing flat surface of the second flat plate busbar are disposed to face each other with an insulating resin therebetween, it is difficult to ensure sufficient reliability in electric insulating property.

In particular, if the insulating resin between the first and second flat plate busbars is made thin in order to downsize the busbar assembly in the vertical direction, there is a risk that a leakage current flows between the first and second busbars.

Moreover, there is a case in which a light emitting element such as a LED is mounted on a surface of the busbar assembly to form a light source unit. In such a case, a sealing resin is mounted on the surface of the busbar assembly in order to protect light emitting element such as a LED.

For example, Patent Literatures 3 below discloses a light source module including a metal core substrate, a sub-mount substrate and a wiring substrate, wherein the sub-mount substrate on which LEDs are mounted and the wiring substrate on which wirings for supplying electric power to the LEDs are arranged are fixed to the metal core substrate, wherein a ring-like plate member having an opening that surrounds the LEDs on the sub-mount substrate and the wiring is fixed on the metal core substrate and the wiring substrate, and wherein the opening in the ring-like plate member is filled with a sealing resin layer.

The arrangement of the ring-like plate member makes it possible to dam a sealing resin material forming the sealing resin layer to effectively prevent the sealing resin material before curing from flowing out.

However, it is needed to prepare the ring-like plate member separate from the metal core substrate, the sub-mount substrate and the wiring substrate, and fix the ring-like plate member to the metal core substrate and the wiring substrate, and whereby it is difficult to reduce the manufacturing cost.

### PRIOR ART DOCUMENT

### Patent Literature

Patent Literature 1: Japanese Patent No. 4432913
Patent Literature 2: JP 2016-216766
Patent Literature 3: JP 2006-269079

### DISCLOSURE OF THE INVENTION

The present invention has been conceived in view of the conventional art described above, and a first object of the present invention is to provide a busbar assembly capable of being downsized in a vertical direction while ensuring electric insulating property between a plurality of busbars, the busbar assembly having a structure of damming a sealing resin material for a semiconductor element such as a LED to be mounted while suppressing cost.

Furthermore, a second object of the present invention is to prove a manufacturing method capable of efficiently manufacturing such a busbar assembly.

In order to achieve the first object, the present invention provides a busbar assembly including a plurality of busbars formed by a conductive flat plate member and disposed in a common plane with a gap being provided therebetween; and an insulating resin layer that includes a connecting portion filled in the gap so as to mechanically connect the plurality of busbars while electrically insulating them and a peripheral wall portion arranged on a first end surface that is positioned on one side in the thickness direction of a busbar connecting body in which the plurality of busbars are connected to one another by the connecting portion, wherein the peripheral wall portion is arranged at a peripheral area of the first end surface of the busbar connecting body so that the busbar connecting body forms at a center in plain view a busbar exposed region at which the first end surfaces of the plurality of busbars are exposed.

Since the busbar assembly according to the present invention includes the plurality of busbars formed by a conductive flat plate member and disposed in a common plane with the gap being provided therebetween; and the insulating resin layer including the connecting portion filled in the gap so as to mechanically connect the plurality of busbars while electrically insulating them and the peripheral wall portion arranged on the first end surface that is positioned on one side in the thickness direction of the busbar connecting body in which the plurality of busbars are connected to one another by the connecting portion, wherein the peripheral wall portion is arranged at a peripheral area of the first end surface of the busbar connecting body so that the busbar connecting body forms at a center in plain view the busbar exposed region at which the first end surfaces of the plurality of busbars are exposed, the busbar assembly makes it possible to be downsized in the vertical direction while ensuring the electric insulating property between the plurality of busbars, and also realize a damming structure by the peripheral wall portion at low cost, the damming structure damming the insulating resin material for sealing the semiconductor element attached to the busbar exposed region.

In a preferable embodiment, the insulating resin layer includes a side wall portion surrounding an outer side surface of the busbar connecting body, and a second end surface portion disposed at a peripheral region of a second end surface on another side in the thickness direction of the busbar connecting body, and the peripheral wall portion, the side wall portion and the second end surface portion are integrally formed.

In a more preferable embodiment, the second end surface of the busbar connecting body has a second-end-surface-side peripheral region at which the second end surface portion is arranged, and a second-end-surface-side center region surrounded by the second-end-surface-side peripheral region and exposing second end surfaces of the plurality of busbars, and an outer surface of the second-end-surface-side peripheral region is positioned closer to one side in the thickness direction than an outer surface of the second-end-surface-side center region is by a distance equal to or less than a thickness of the second end surface portion.

In any one of the above various configurations, the plurality of busbars each are preferably formed with engagement grooves having a first end side opened to areas of the first end surfaces at which the peripheral wall portion is arranged. The engagement groove is formed so that at least a part thereof is arranged at a position different from the first end side with respect to a plate surface direction. The insulating resin layer includes a stopper portion integrally formed with the peripheral wall portion and filled into the engagement groove.

In any one of the above configurations, in a first preferable example, an inner side surface out of outer surfaces of the busbar that faces the adjacent other busbar with the gap being interposed therebetween is configured so as to include a first-end-surface side plate-thickness-direction extending part extending from the first end surface along the plate thickness direction toward another side in the thickness direction and terminating within the thickness of the busbars, a plate-surface-direction extending part extending along the plate surface direction from an end of the first-end-surface side plate-thickness-direction extending part that is positioned on another side in the thickness direction toward the separating side from the other busbar, and a second-end-surface-side plate-thickness-direction extending part extending along the plate thickness direction from an end of the plate-surface-direction extending part that is positioned on the separating side from the other busbar toward another side in the thickness direction and reaching the second end surface.

In the first example, the insulating resin layer preferably includes a first-end-surface-side center portion integrally formed with the connecting portion and arranged on the first end surface (21) of the busbar connecting body.

The first-end-surface-side center portion is configured so as to extend between a position away from an end of the first-end-surface-side plate-thickness-direction extending part that is positioned on one side in the thickness direction in one busbar of the adjacent busbars toward the separating side from the other busbar of the adjacent busbars by a predetermined distance and a position away from an end of the first-end-surface-side plate-thickness-direction extending part that is positioned on one side in the thickness direction in the other one busbar of the adjacent busbars toward the separating side from the one busbar of the adjacent busbars by a predetermined distance.

In any one of the above configurations, in a second preferable example, an inner side surface out of outer surfaces of the busbar that faces the adjacent other busbar with the gap being interposed therebetween is configured so as to include a first-end-surface side plate-thickness-direction extending part extending along the plate thickness direction from the first end surface toward another side in the thickness direction, a first-end-surface-side plate-surface-direction extending part extending along the plate surface direction from an end of the first-end-surface-side plate-thickness-direction extending part that is positioned on another side in the thickness direction toward the approaching side to the adjacent other busbar, a center plate-thickness-direction extending part extending along the plate thickness direction from an end of the first-end-surface-side plate-surface-direction extending part that is positioned on the closer side to the other busbar toward another side in the thickness direction, a second-end-surface-side plate-surface-direction extending part extending along the plate surface direction from an end of the center plate-thickness-direction extending part that is positioned on another side in the thickness direction toward the separating side from the other busbar, and a second-end-surface-side plate-thickness-direction extending part extending along the plate thickness direction from an end of the second-end-surface-side plate-surface-direction extending part that is positioned on the separating side from the other busbar toward another side in the thickness direction and reaching the second end surface.

In any one of the above configurations, in a third preferable example, an inner side surface out of outer surfaces of the busbar that faces the adjacent other busbar with the gap being interposed therebetween is configured so as to include a first-end-surface-side inclined part inclined so as to come closer to the other busbar from the first end surface toward another side in the thickness direction, and a second-end-surface-side inclined part inclined so as to come closer to the other busbar from the second end surface toward the one side in the thickness direction.

In any one of the above configurations, in a fourth preferable example, an inner side surface out of outer surfaces of the busbar that faces the adjacent other busbar with the gap being interposed therebetween is configured so as to include a portion inclined so that the gap is gradually narrowed from one toward the other of the first and second end surfaces.

In order to achieve the second object, the present invention provides a method for manufacturing a busbar assembly including a plurality of busbars formed by a conductive flat plate member and disposed in a common plane with a gap being provided therebetween; and an insulating resin layer including a connecting portion filled in the gap so as to mechanically connect the plurality of busbars while electrically insulating them and a peripheral wall portion arranged on a first end surface that is positioned on one side in the thickness direction of a busbar connecting body in which the plurality of busbars is connected to each other by the connecting portion, wherein the peripheral wall portion is arranged at a peripheral area of the first end surface of the busbar connecting body so that a busbar exposed region at which the first end surfaces of the plurality of busbars are exposed is formed at a center of the busbar connecting body in plain view, the method including: a busbar forming body setting step of preparing a plurality of busbar forming bodies that has the same material, the same shape and the same thickness as those of the plurality of busbars and arranging the plurality of busbar forming bodies in the common plane with the gap being provided therebetween; a step of setting a mold capable of selectively taking an installation state of surrounding the plurality of busbar forming bodies so as to define a peripheral-wall-portion forming space corresponding to the peripheral wall portion and a disassembled state of removed from the plurality of busbar forming bodies, the mold having a peripheral-wall-portion injection hole communicated with the peripheral-wall-portion forming space and a connecting-portion injection hole communicated with the gap; an injection step of injecting an insulating resin material that forms the peripheral wall portion and the connecting portion into the mold through the peripheral-wall-portion injection hole and the connecting-portion injection hole; a resin curing step of curing the insulating resin material to form the peripheral wall portion and the connecting portion; a disassembling step of disassembling the mold; and a taking-out step of taking out the busbar assembly.

The method for manufacturing a busbar assembly according to the present invention makes it possible to efficiently and inexpensively manufacture the busbar assembly capable of being downsized in the vertical direction while ensuring electric insulating property between the plurality of busbars, and having the structure of damming the sealing resin material.

In a case where the insulating resin layer includes a side wall portion surrounding an outer side surface of the busbar connecting body and a second end surface portion disposed at a peripheral region of a second end surface of the busbar connecting body positioned on another side in the thickness direction, the mold is configured so as to define a side-wall-portion forming space corresponding to the side wall portion and a second-end-surface-portion forming space corresponding to the second end surface portion in the installation state, and the peripheral-wall-portion forming space, the side-wall-portion forming space and the second-end-surface-portion forming space are communicated with one another.

In the case where the insulating resin layer includes, in addition to the peripheral wall portion, the side wall portion and the second end surface portion, the busbar forming body is preferably configured so that an area corresponding to a second-end-surface-side peripheral region out of the second end surface of the busbar connecting body at which the second end surface portion is arranged is thinner than the other area so that the second-end-surface-side peripheral region is positioned closer to one side in the thickness direction than a second-end-surface-side center region out of the second end surface of the busbar connecting body that is surrounded by the second-end-surface-side peripheral region is by a distance equal to or less than a thickness of the second end surface portion.

In a preferable embodiment, the busbar forming body setting step includes a step of preparing a conductive metal flat plate that has the same thickness as that of the busbar, the conductive metal flat plate including a busbar assembly forming region that has the same width as that of the busbar assembly; and a slit forming step of forming one or a plurality of slits in the busbar assembly forming region that penetrates between first and second end surfaces on one and another sides in the thickness direction, respectively, the slit having the same shape and width as those of the gap to realize a state where the plurality of busbar forming bodies are disposed in the common plane with the gap being provided therebetween.

In a case where the busbar forming body setting step includes the step of preparing the conductive metal flat plate and the slit forming step, the conductive metal flat plate preferably has a plurality of the busbar assembly forming regions disposed in the X direction, which is parallel to the longitudinal direction of the slit, in the X-Y plane where the conductive metal flat plate is located, and connecting regions connecting the busbar assembly forming regions adjacent in the X direction.

In this case, the manufacturing method is configured so as to further include a step of cutting off the busbar assembly forming region from the conductive metal flat plate after the resin curing step and after or before the disassembling step.

In a more preferable embodiment, the conductive metal flat plate has a plurality of busbar assembly forming strips each including the plurality of busbar assembly forming regions disposed in the X direction and the connecting regions connecting the busbar assembly forming regions adjacent in the X direction, the plurality of busbar assembly forming strips disposed in parallel in the Y direction; a first connecting strip connecting the end parts on one side in the X direction of the plurality of busbar assembly forming strips to one another; and a second connecting strip connecting the end parts on another side in the X direction of the plurality of busbar assembly forming strips to one another.

### BRIEF DESCRIPTION OF THE DRAWINGS

[FIG. 1]

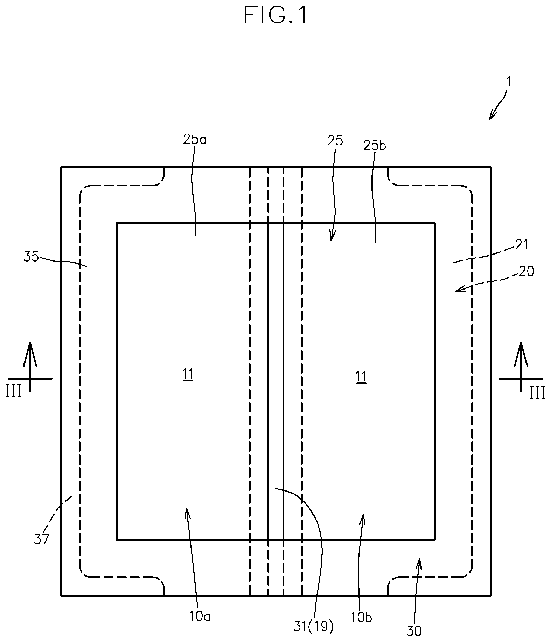

   FIG. 1 a plane view of a busbar assembly according to one embodiment of the present invention.
[FIG. 2]

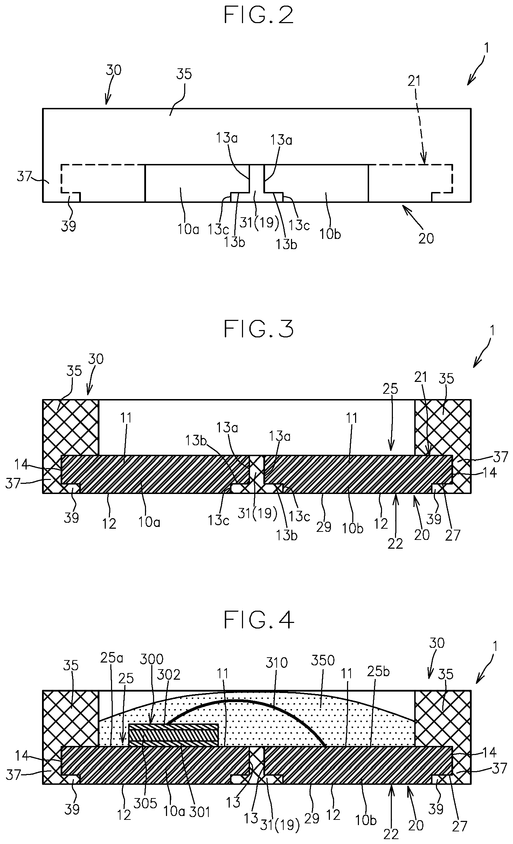

   FIG. 2 is a front view of the busbar assembly.
[FIG. 3]
   FIG. 3 is a cross-sectional view taken along the line III-III in FIG. 1.
[FIG. 4]
   FIG. 4 is a cross-sectional view of one example of a semiconductor module in which a semiconductor element is attached to the busbar assembly.
[FIG. 5]

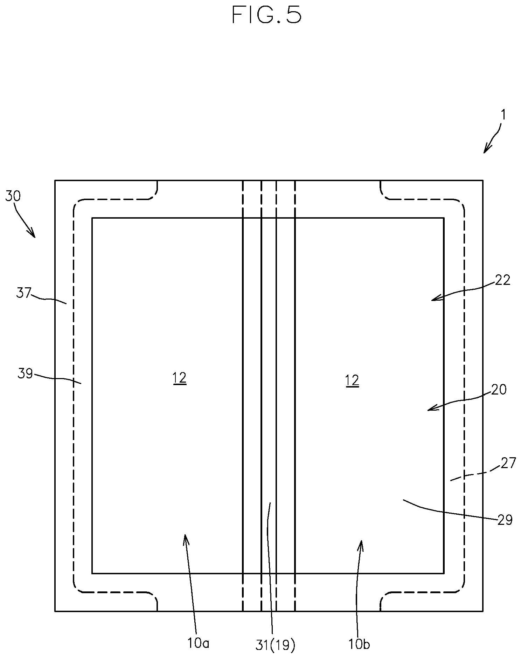

   FIG. 5 is a bottom view of the busbar assembly.
[FIG. 6]

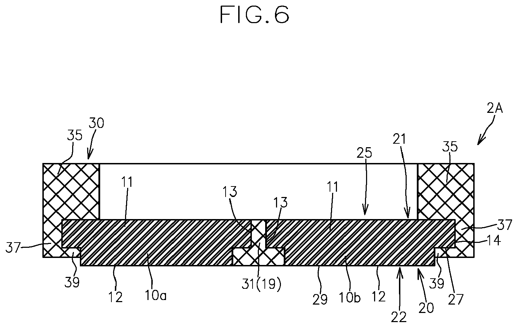

   FIG. 6 is a vertical cross-sectional view of a busbar assembly according to a first modified example of the embodiment.
[FIG. 7]

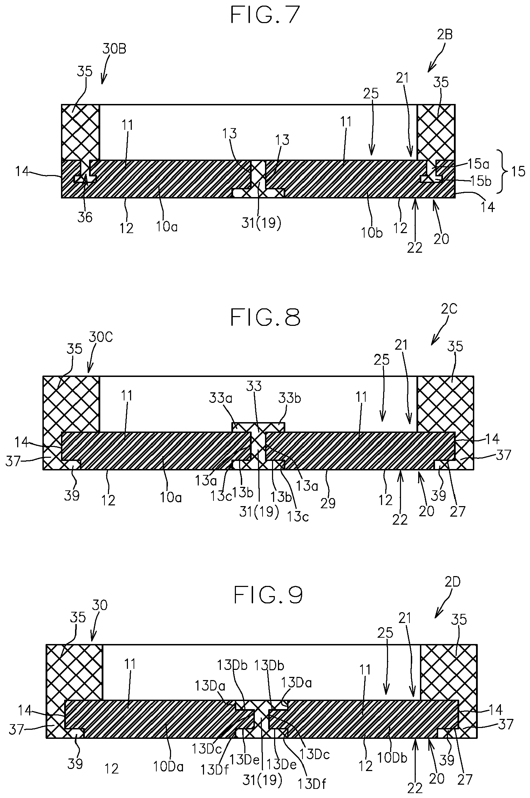

   FIG. 7 is a vertical cross-sectional view of a busbar assembly according to a second modified example of the embodiment.
[FIG. 8]
   FIG. 8 is a vertical cross-sectional view of a busbar assembly according to a third modified example of the embodiment.
[FIG. 9]
   FIG. 9 is a vertical cross-sectional view of a busbar assembly according to a fourth modified example of the embodiment.
[FIG. 10]

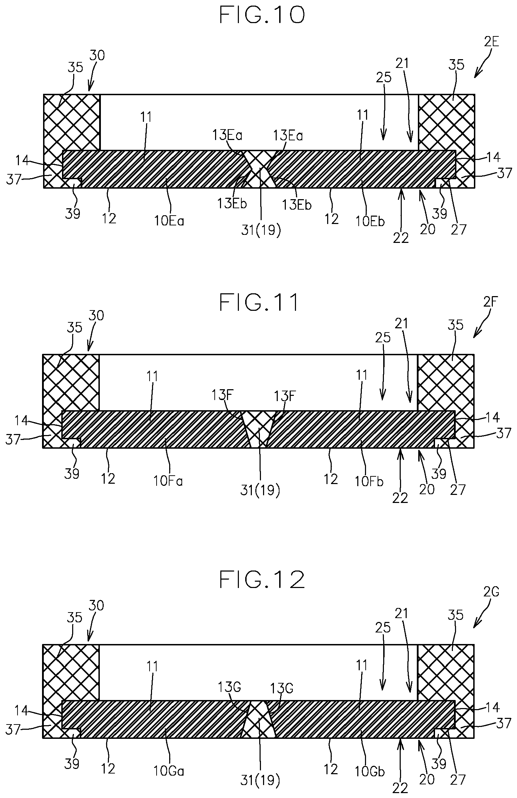

   FIG. 10 is a vertical cross-sectional view of a busbar assembly according to a fifth modified example of the embodiment.
[FIG. 11]
   FIG. 11 is a vertical cross-sectional view of a busbar assembly according to a sixth modified example of the embodiment.
[FIG. 12]
   FIG. 12 is a vertical cross-sectional view of a busbar assembly according to a seventh modified example of the embodiment.
[FIG. 13]

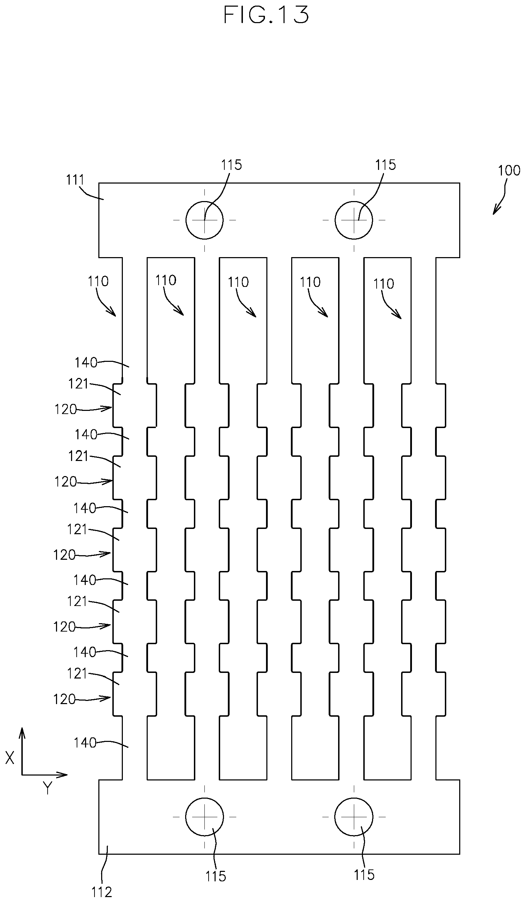

   FIG. 13 is a plan view of a conductive metal flat plate used in one example of a manufacturing method of the busbar assembly according to the embodiment.
[FIG. 14]

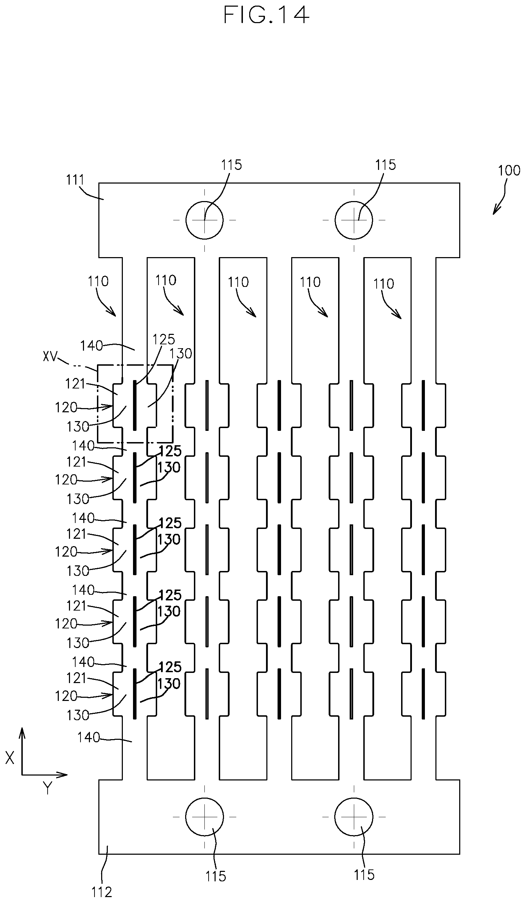

   FIG. 14 is a plan view of the conductive metal flat plate after a slit forming step in the manufacturing method.
[FIG. 15]

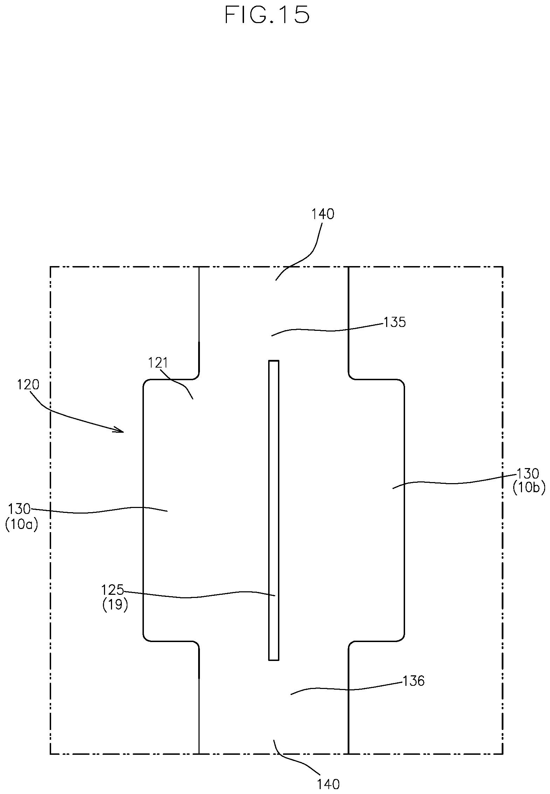

   FIG. 15 is.an enlarged view of the XV part in FIG. 14.
[FIG. 16]

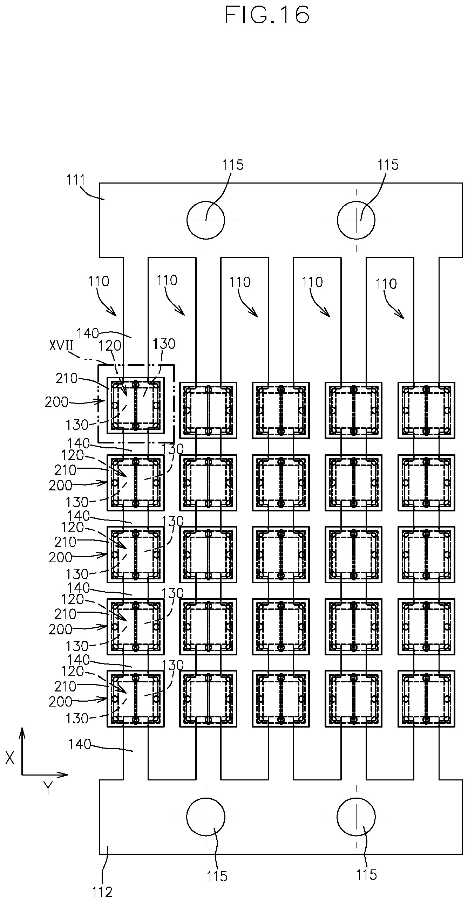

   FIG. 16 is a plan view of the conductive metal flat plate after with a mold setting step in the manufacturing method.
[FIG. 17]

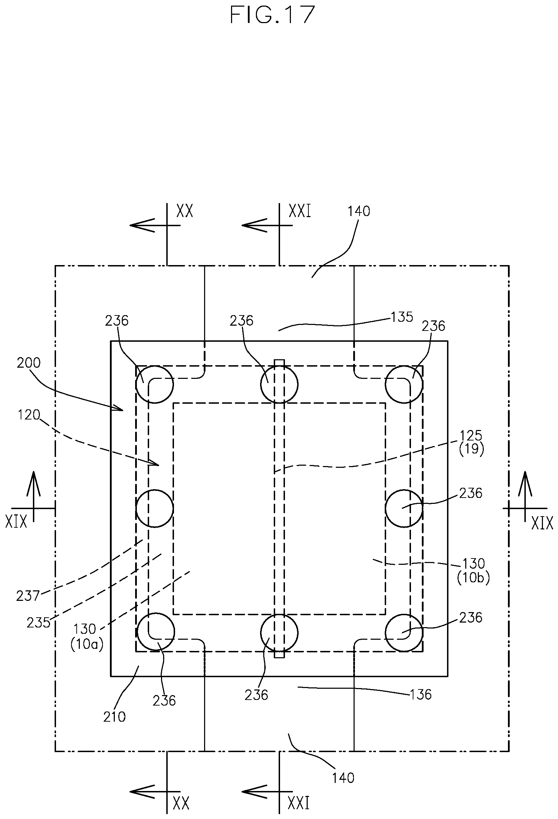

   FIG. 17 is an enlarged view of the XVII part in FIG. 16.
[FIG. 18]

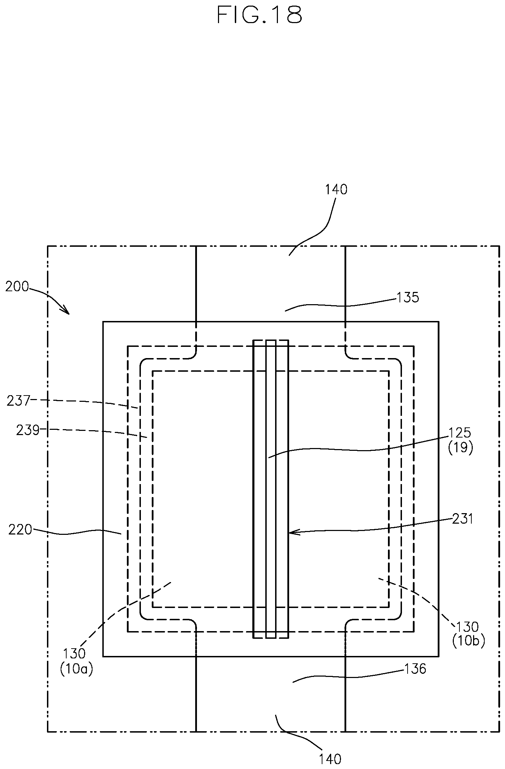

   FIG. 18 is a bottom view of FIG. 17.
[FIG. 19]

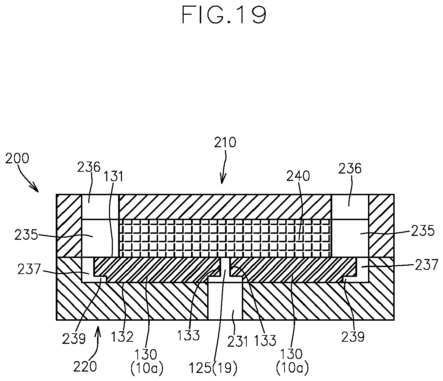

   FIG. 19 is a cross-sectional view taken along the line XIX-XIX in FIG. 17.
[FIG. 20]

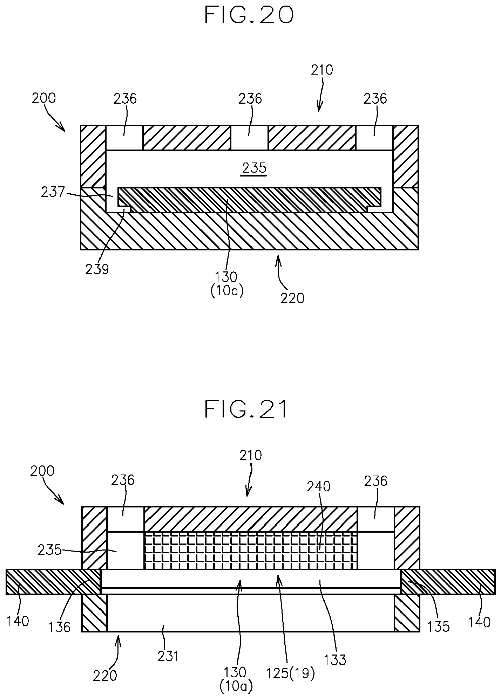

   FIG. 20 is a cross-sectional view taken along the line XX-XX in FIG. 17.
[FIG. 21]
   FIG. 21 is a cross-sectional view taken along the line XXI-XXI in FIG. 17.
[FIG. 22]

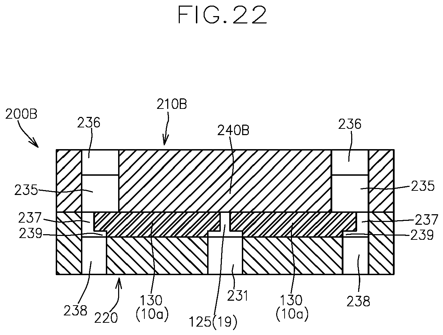

   FIG. 22 is a vertical cross-sectional view in a case where a modified example of the mold is used.
[FIG. 23]

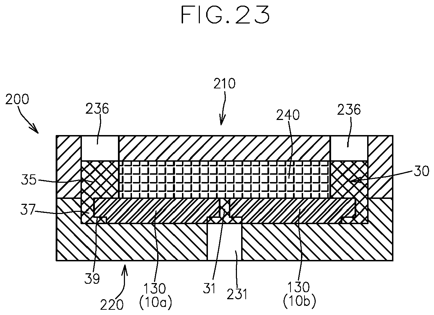

   FIG. 23 is a vertical cross-sectional view after a resin curing step in the manufacturing method.
[FIG. 24]

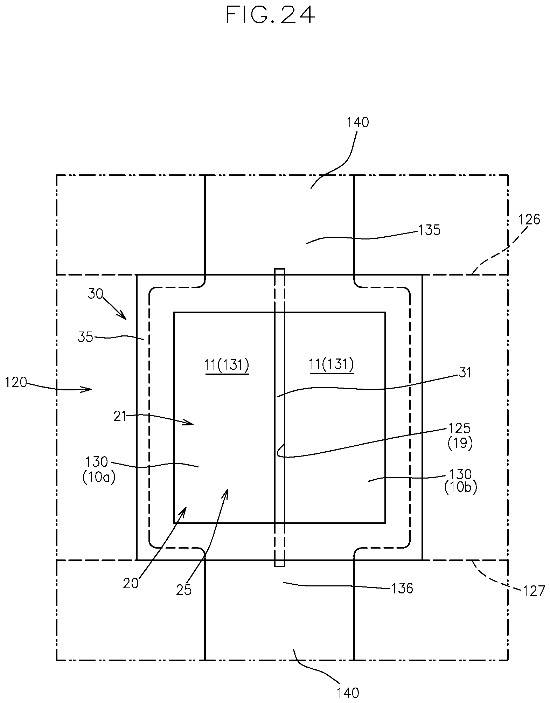

   FIG. 24 is a plan view after a disassembling step in the manufacturing method.

### EMBODIMENT FOR CARRYING OUT THE INVENTION

Below, one embodiment of a busbar assembly according to the present invention will be described with reference to the appended drawings.

FIGS. 1 and 2 show a plane view and a front view of a busbar assembly 1 according to the present embodiment, respectively.

FIG. 3 shows a cross-sectional view taken along the line III-III in FIG. 1.

As shown in FIGS. 1 to 3, the busbar assembly 1 has a plurality of busbars 10 formed of a conductive plate-like member and disposed in a common plane with a gap 19 being provided between respective inner side surfaces 13, and an insulating resin layer 30 including a connecting portion 31 that is filled in the gap 19 to mechanically connect the plurality of busbars 10 while electrically insulating one another.

As shown in FIGS. 1 to 3, the busbar assembly 1 has two busbars of first and second busbars 10a, 10b as the plurality of busbars 10.

As shown in FIG.3, the first and second busbars 10a, 10b each include, as viewed in a vertical cross-sectional diagram taken in the thickness direction, first surfaces 11 on a first side in the thickness direction, second surfaces 12 on a second side that is opposite from the first side in the thickness direction, the inner side surfaces 13 facing each other, and outer side surfaces 14 facing mutually opposite directions.

The first and second busbars 10a, 10b are formed of a conductive metal flat plate of Cu or the like.

In accordance with specification, the plurality of busbars 10 (the first and second busbars 10a, 10b in the present embodiment) may have the same shape to each other or have different shapes from each other.

That is, for example, in a case where three busbars 10 are disposed in a common plane, the three busbars 10 may have the same shape, or a busbar arranged at a center has a width different from that of busbars arranged at both sides, in accordance with specification. Alternatively, the three busbars have different shapes from one another.

The insulating resin layer 30 is formed of a resin having heat resistance and insulating properties, and, for example, polyimide, polyamide, epoxy, or the like is preferably used.

As shown in FIGS. 1 to 3, the insulating resin layer 30 includes a peripheral wall portion 35 arranged on a first end surface 21 that is positioned on one side in the thickness direction of a busbar connecting body 20 formed by connecting the plurality of busbars 10a, 10b by the connecting portion 31, in addition to the connecting portion 31.

The peripheral wall portion 35 is arranged at a peripheral area of the first end surface 21 of the busbar connecting body 20 so that a busbar exposed region 25 at which the first end surfaces 11 of the plurality of busbars 10a, 10b are exposed is formed at a center of the first end surface 21 of the busbar connecting body 20 in plain view.

The busbar exposed region 25 functions as a mounting surface to which semiconductor element 300 such as an LED is attached.

FIG. 4 shows a cross-sectional view of one example of a semiconductor module in which the semiconductor element 300 such as an LED is attached to the busbar exposed region 25.

The busbar exposed region 25 includes a first busbar exposed region 25a where the first end surface 11 of the first busbar 10a is exposed, and a second busbar exposed region 25b where the first end surface 11 of the second busbar 10b is exposed.

As shown in FIG. 4, the semiconductor element 300 is mounted to one (for example, the first busbar exposed region 25a) of the first busbar exposed region 25a and the second busbar exposed region 25b.

Specifically, the semiconductor element 300 has first and second electrode layers 301, 302 arranged at a lower surface on one side in the thickness direction and an upper surface on another side in the thickness direction, respectively.

The first electrode layer 301 of the semiconductor element 300 is fixed to one (for example, the first busbar exposed region 25a) of the first busbar exposed region 25a and the second busbar exposed region 25b with electrically connected to the same, and the second electrode layer 302 is electrically connected to the other one (for example, the second busbar exposed region 25b) of the first busbar exposed region 25a and the second busbar exposed region 25b via an electrical connecting member 310 such as wire boding.

Preferably, each of the first and second busbars 10a, 10b is provided at the first end surface 11 with a plated layer (not shown).

In this case, the first electrode layer 301 of the semiconductor element 300 is die-bonded so as to be electrically connected to the plated layer that is exposed through one (for example, the first busbar exposed region 25a) of the first busbar exposed region 25a and the second busbar exposed region 25b, and the second electrode layer 302 is electrically connected to the plated layer that is exposed through the other one (for example, the second busbar exposed region 25b) of the first busbar exposed region 25a and the second busbar exposed region 25b via wire bonding 310.

The peripheral wall portion 35 functions as a damming structure preventing a sealing resin layer 350 (see FIG. 4) from flowing out, the sealing resin layer 350 sealing the semiconductor element 300 that is attached to the busbar exposed region 25.

That is, a busbar assembly including first and second busbars and configured so that a semiconductor element can be mounted to one of the first and second busbars is needed to include a damming structure that prevents a resin material, which forms a sealing resin layer for sealing the semiconductor, from flowing out when the resin material is applied and cured.

For example, it is possible to form a damming structure by manufacturing a frame that is separate from the first and second busbars and has such a shape as to surround the semiconductor element to be mounted in a plan view, and then fixing the frame to a peripheral region of a busbar connecting body formed by the first and second busbars.

However, in this damming structure, it is needed to prepare the frame separate from the first and second busbars, and then fix the frame to the first and second busbars.

On the other hand, the busbar assembly 1 according to the present embodiment makes it possible to easily realize the damming structure preventing the resin material, which forms the sealing resin layer 350, from flowing out before curing, without the separate frame.

As shown in FIGS. 3 and 4, in the busbar assembly 1 according to the present embodiment, the insulating resin layer 30 further includes a side wall portion 37 surrounding an outer side surface of the busbar connecting body 20, and a second end surface portion 39 disposed at a peripheral region of a second end surface 22 of the busbar connecting body 20 on the second side in the thickness direction.

The peripheral wall portion 35, the side wall portion 37 and the second end surface portion 39 are integrally formed, and has a U-shape in cross section so as to sandwich the peripheral edge of the busbar connecting body 20.

The configuration makes it possible to effectively prevent the peripheral wall portion 35 from being separated from the busbar connecting body 20.

FIG.5 shows a bottom view of the busbar assembly 1.

As shown in FIGS. 3 to 5, the second end surface portion 39 is arranged so that a center part of the second end surface 22 of the busbar connecting body 20 is exposed.

Specifically, the second end surface portion 39 is arranged only at a second-end-surface-side peripheral region 27 of the second end surface 22 of the busbar connecting body 20 so that the second end surface 22 of the busbar connecting body 20 is exposed at a second-end-surface-side center region 29 surrounded by the second-end-surface-side peripheral region 27.

As shown in FIG. 3 or the like, in the present embodiment, an outer surface of the second-end-surface-side peripheral region 27 is positioned closer to the first side in the thickness direction than an outer surface of the second-end-surface-side center region 29 is by a distance corresponding to a thickness of the second end surface portion 39.

That is, the outer surface of the second end surface portion 39 is flush with the outer surface of the second-end-surface-side center region 29.

The configuration makes it possible to stabilize posture of the busbar assembly 1, and, for example, adhere surely an ultrasonic welding equipment to the second end surface 12 of the first and second busbars 10a, 10b when attaching the wire bonding 310 or the like with using the ultrasonic welding equipment thereby enhancing workability of ultrasonic welding.

In the present embodiment, the outer surface of the second-end-surface-side peripheral region 27 is positioned closer to the first side in the thickness direction than the outer surface of the second-end-surface-side center region 29 is by a distance corresponding to the thickness of the second end surface portion 39. Alternatively, it is possible to modify so that the outer surface of the second-end-surface-side peripheral region 27 is positioned closer to the first side in the thickness direction than the outer surface of the second-end-surface-side center region 29 is only by a distance less than the thickness of the second end surface portion 39.

FIG. 6 shows a vertical cross-sectional view of a first modified example 2A that is modified in such a manner.

In the first modified example 2A, the second-end-surface-side center region 29 is extended further outward than the second end surface portion 39.

The thus configured busbar assembly 2 also makes it possible to stabilize posture.

FIG. 7 shows a vertical cross-sectional view of a busbar assembly 2B according to a second modified example of the present embodiment.

The second modified example 2B includes an insulating resin layer 30B in place of the insulating resin layer 30 in comparison with the present embodiment 1.

The insulating resin layer 30B includes a stopper portion 36 in place of the side wall portion 37 and the second end surface portion 39 in comparison with the insulating resin layer 30.

Specifically, as shown in FIG. 7, in the second modified example 2B, the first and second busbars 10a, 10b each are formed with engagement grooves 15 having a first end side opened to areas of the first end surfaces 11 at which the peripheral wall portion 35 is arranged.

The engagement groove 15 is formed so that at least a part thereof is arranged at a position different from the first end side with respect to a plate surface direction.

In the second modified example 2B, the engagement groove 15 has a vertical groove portion 15a having a first end portion that forms the first end side and extending in a vertical direction from the first end portion, and a horizontal groove portion 15b extending in a horizontal direction from a second end portion of the vertical groove portion 15a that is opposite from the first end portion.

The stopper portion 36 is integrally formed with the peripheral wall portion 35 and filled into the engagement groove 15.

The second modified example 2B also makes it possible to effectively prevent the peripheral wall portion 35 from being separated from the busbar connecting body 20.

As shown in FIGS. 2 to 4, in the busbar assembly 1 according to the present embodiment, the inner side surface 13 includes a first-end-surface side plate-thickness-direction extending part 13a extending from the first end surface 11 along the plate thickness direction toward the second side in the thickness direction and terminating within the thickness of the busbars 10a, 10b, a plate-surface-direction extending part 13b extending along the plate surface direction from an end of the first-end-surface side plate-thickness-direction extending part 13a that is positioned on the second side in the thickness direction toward the separating side from the other busbar, and a second-end-surface-side plate-thickness-direction extending part 13c extending along the plate thickness direction from an end of the plate-surface-direction extending part 13b that is positioned on the separating side from the other busbar toward the second side in the thickness direction and reaching the second end surface 12.

The configuration makes it possible to effectively prevent the connecting portion 31 from being separated toward the first side in the thickness direction from the busbar assembly 1.

As a matter of course, it is possible to modify the present embodiment so as to effectively prevent the connecting portion 31 from being separated toward the second side in the thickness direction from the busbar assembly 1.

In such a modified example, the second-end-surface-side plate-thickness-direction extending part 13c is modified so as to extend from the second end surface 12 along the plate thickness direction toward the first side in the thickness direction and terminate within the thickness of the busbars 10a, 10b, the plate-surface-direction extending part 13b is modified so as to extend from an end of the second-end-surface-side plate-thickness-direction extending part 13c that is positioned on the first side in the thickness direction along the plate surface direction toward the separating side from the other busbar, and the first-end-surface-side plate-thickness-direction extending part 13a is modified so as to extend from the end of the plate-surface-direction extending part 13b that is positioned on the separating side from the other busbar along the plate thickness direction toward the first side in the thickness direction and reach the first end surface 11. Thus, in the modified example, the connecting portion 31 has a T-shape in vertical cross section.

FIG. 8 shows a vertical cross-sectional view of a busbar assembly 2C according to a third modified example of the present embodiment.

The third modified example 2C includes an insulating resin layer 30C in place of the insulating resin layer 30 in comparison with the present embodiment 1.

The insulating resin layer 30C further includes a first-end-surface-side center portion 33 arranged on the first end surface 21 of the busbar connecting body with being integrally formed with the connecting portion 31 in comparison with the insulating resin layer 30.

The first-end-surface-side center portion 33 is provided to extend between a position 33a away from an end of the first-end-surface-side plate-thickness-direction extending part 13a that is positioned on the first end side in the thickness direction in one busbar 10a of the adjacent busbars 10a, 10b toward the separating side from the other busbar 10b by a predetermined distance and a position 33b away from an end of the first-end-surface-side plate-thickness-direction extending part 13a that is positioned on the first end side in the thickness direction in the other one busbar 10b toward the separating side from the one busbar 10a by a predetermined distance.

The third modified example 2C with the configuration makes it possible to effectively prevent the connecting portion 31 from being separated toward both the first and second sides in the thickness direction from the busbar assembly 2C.

FIG. 9 shows a vertical cross-sectional view of a busbar assembly 2D according to a fourth modified example of the present embodiment.

The fourth modified example 2D includes first and second busbars 10Da, 10Db in place of the first and second busbars 10a, 10b in comparison with the present embodiment 1.

The busbar 10D has an inner side wall 13D in place of the inner side wall 13 in comparison with the busbar 10.

As shown in FIG. 9, the inner side wall 13D includes a first-end-surface side plate-thickness-direction extending part 13Da extending along the plate thickness direction from the first end surface 11 toward the second side in the thickness direction, a first-end-surface-side plate-surface-direction extending part 13Db extending along the plate surface direction from an end of the first-end-surface-side plate-thickness-direction extending part 13Da that is positioned on the second side in the thickness direction toward the approaching side to the other busbar 10b, a center plate-thickness-direction extending part 13Dc extending along the plate thickness direction from an end of the first-end-surface-side plate-surface-direction extending part 13Db that is positioned on the closer side to the other busbar toward the second side in the thickness direction, a second-end-surface-side plate-surface-direction extending part 13De extending along the plate surface direction from an end of the center plate-thickness-direction extending part 13Dc that is positioned on the second side in the thickness direction toward the separating side from the other busbar 10b, and a second-end-surface-side plate-thickness-direction extending part 13Df extending along the plate thickness direction from an end of the second-end-surface-side plate-surface-direction extending part 13De that is positioned on the separating side from the other busbar toward the second side in the thickness direction and reaching the second end surface 12.

The fourth modified example 2D with the configuration also makes it possible to effectively prevent the connecting portion 31 from being separated toward both the first and second sides in the thickness direction from the busbar assembly 2D.

FIG. 10 shows a vertical cross-sectional view of a busbar assembly 2E according to a fifth modified example of the present embodiment.

The fifth modified example 2E includes first and second busbars 10Ea, 10Eb in place of the first and second busbars 10a, 10b in comparison with the present embodiment 1.

The busbar 10E has an inner side wall 13E in place of the inner side wall 13 in comparison with the busbar 10.

As shown in FIG. 10, the inner side surface 13E includes a first-end-surface-side inclined part 13Ea inclined so as to come closer to the other busbar from the first end surface 11 toward the second side in the thickness direction, and a second-end-surface-side inclined part 13Eb inclined so as to come closer to the other busbar from the second end surface 12 toward the first side in the thickness direction.

The fifth modified example 2E with the configuration also makes it possible to effectively prevent the connecting portion 31 from being separated toward both the first and second sides in the thickness direction from the busbar assembly 2E.

In the fifth modified example 2E, the first-end-surface-side inclined part 13Ea and the second-end-surface-side inclined part 13Eb are directly connected to each other. However, it is possible that the inner side surface includes a center part extending in the thickness direction between therebetween.

It is also possible that the first-end-surface-side inclined part 13Ea is inclined so as to separate from the other busbar from the first end surface 11 toward the second side in the thickness direction, and the second-end-surface-side inclined part 13Eb is inclined so as to separate from the other busbar from the second end surface 12 toward the first side in the thickness direction.

FIG. 11 shows a vertical cross-sectional view of a busbar assembly 2F according to a sixth modified example of the present embodiment.

The sixth modified example 2F includes first and second busbars 10Fa, 10Fb in place of the first and second busbars 10a, 10b in comparison with the present embodiment 1.

The busbar 10F has an inner side wall 13F in place of the inner side wall 13 in comparison with the busbar 10.

As shown in FIG. 11, at least a part of the inner side surface 13F is inclined so that the gap 19 is gradually narrowed from the first end surface 11 toward the second end surface 12.

The configuration shown in FIG. 11, the whole of the inner side surface 13F is inclined.

The sixth modified example 2F with the configuration makes it possible to effectively prevent the connecting portion 31 from being separated toward the second side in the thickness direction from the busbar assembly 2F.

FIG. 12 shows a vertical cross-sectional view of a busbar assembly 2G according to a seventh modified example of the present embodiment.

The seventh modified example 2G includes first and second busbars 10Ga, 10Gb in place of the first and second busbars 10a, 10b in comparison with the present embodiment 1.

The busbar 10G has an inner side wall 13G in place of the inner side wall 13 in comparison with the busbar 10.

As shown in FIG. 12, at least a part of the inner side surface 13G is inclined so that the gap 19 is gradually narrowed from the second end surface 12 toward the first end surface 11.

The configuration shown in FIG. 12, the whole of the inner side surface 13G is inclined.

The seventh modified example 2G with the configuration makes it possible to effectively prevent the connecting portion 31 from being separated toward the first side in the thickness direction from the busbar assembly 2G.

Next, an example of a method for manufacturing the busbar assembly 1 will now be described.

The manufacturing method includes a busbar forming body setting step of preparing a plurality of busbar forming bodies 130 that has the same material, the same shape and the same thickness as those of the plurality of busbars 10 and arranging the plurality of busbar forming bodies 130 on a common plane with the gap 19 being provided therebetween; a step of setting a mold 200 so as to surround the plurality of busbar forming bodies 130; an injection step of injecting an insulating resin material forming the insulating resin layer 30 into the mold 200; a resin curing step of curing the insulating resin material; a disassembling step of disassembling the mold 200; and a taking-out step of taking out the busbar assembly 1.

In a case where the plurality of busbars include the first and second busbars 10a, 10b, preparing the plurality of busbar forming bodies that has the same material, the same shape and the same thickness as those of the plurality of busbars 10 means preparing a first busbar forming body that has the same material, the same shape and the same thickness as those of the busbar 10a and a second busbar forming body that has the same material, the same shape and the same thickness as those of the busbar 10b.

In the present embodiment, the busbar forming body setting step includes a step of preparing a conductive metal flat plate 100 of Cu or the like that has the same material and thickness as those of the busbar 10, the conductive metal flat plate 100 including a busbar assembly forming region 120 that has the same width as that of the busbar assembly 1; and a slit forming step of forming one or a plurality of slits 125 in the busbar assembly forming region 120 that penetrates between a first end surface 121 on one side in the thickness direction and a second end surface 122 on another side in the thickness direction, the slit having the same shape and width as those of the gap 19 to realize the plurality of busbar forming bodies 130 disposed in the common plane with the gap being provided therebetween.

The busbar assembly forming region 120 has a width defined by sum of the widths of the plurality of busbars 10 and the width of the gap 19.

As described above, the busbar assembly 1 according to the present embodiment includes two busbars having the first and second busbars 10a, 10b as the plurality of busbars 10 so that only a single gap 19 is provided between the first and second busbars 10a, 10b.

In this case, the busbar assembly forming region 120 has a width defined by sum of the widths of the first and second busbars 10a, 10b and the gap 19.

The configuration makes it possible to efficiently realize a situation in which the plurality of busbar forming bodies 130 are arranged in a common plane with the gap 19 being provided therebetween.

FIG. 13 shows a plan view of the conductive metal flat plate 100 used in the manufacturing method.

FIG. 14 shows a plan view of the conductive metal flat plate 100 after the slit forming step is complete.

FIG. 15 shows an enlarged view of the XV part in FIG. 14.

As shown in FIG. 15, in the present embodiment, the conductive metal flat plate 100 after the slit forming step is configured such that the pair of busbar forming bodies 130, 130 facing each other with the slit 125 therebetween remain connected to each other via a connecting part 135 of the conductive metal flat plate 100 located more toward one side in the longitudinal direction of the slit 125 than the slit 125 is and a connecting part 136 of the conductive metal flat plate 100 located more toward another side in the longitudinal direction of the slit 125 than the slit 125 is.

Due to this configuration, the slit 125, that is the gap 19, can be formed highly accurately.

In the present embodiment, as shown in FIGS. 13 and 14, the conductive metal flat plate 100 has a plurality of (five in the depicted configuration) the busbar assembly forming regions 120 disposed in the X direction, which is parallel to the longitudinal direction of the slit 125, in the X-Y plane where the conductive metal flat plate 100 is located, and connecting regions 140 for connecting the busbar assembly forming regions 120 adjacent in the X direction.

The configuration makes it possible to simultaneously process the plurality of busbar assembly forming regions 120.

The connecting parts 135, 136 are formed by the connecting region 140.

Moreover, in the present embodiment, as shown in FIGS. 13 and 14, the plurality of busbar assembly forming regions 120 disposed in the X direction and the connecting regions 140 connecting the busbar assembly forming regions 120 adjacent in the X direction form a busbar assembly forming strip 110, and a plurality of the busbar assembly forming strips 110 are disposed in parallel in the Y direction perpendicular to the X direction in the X-Y plane.

Specifically, in the embodiment shown in FIGS. 13 and 14, the conductive metal flat plate 100 has a plurality of (five in the depicted embodiment) busbar assembly forming strips 110 disposed in parallel in the Y direction, a first connecting strip 111 for connecting the end parts on one side in the X direction of the plurality of busbar assembly forming strips 110 to one another, and a second connecting strip 112 for connecting the end parts on another side in the X direction of the plurality of busbar assembly forming strips 110 to one another.

The busbar assembly forming regions 120 that are located furthest outward in the X direction are connected to the first and second connecting strips 112 via the connecting regions 140.

With the conductive metal flat plate 100 thus configured, a greater number of busbar assemblies 1 can be simultaneously manufactured.

A reference numeral 115 denotes a positioning hole for the conductive metal flat plate 100.

The mold 200 is configured so as to take an installation state of surrounding the plurality of busbar forming bodies 130 and a disassembled state of having the plurality of busbar forming bodies 130 capable of being taken out.

FIG. 16 shows a plan view of the conductive metal flat plate 100 with the mold 200 being installed.

FIG. 17 shows an enlarged view of the XVII part in FIG. 16.

FIG. 18 is a bottom view of FIG. 17.

FIG. 19 to 21 are cross-sectional views taken along the lines XIX-XIX, XX-XX and XXI-XXI in FIG. 17, respectively.

As shown in FIGS. 19 to 21, the mold 200 in the installation state is configured so as to define a peripheral-wall-portion forming space 235 corresponding to the peripheral wall portion 35, and has a peripheral-wall-portion injection hole 236 communicated with the peripheral-wall-portion forming space 235 and a connecting-portion injection hole 231 communicated with the slit 125 that forms the gap 19.

In the present embodiment, as shown in FIGS. 19 to 21, the mold 200 has first and second molds 210, 220 separable from each other in the thickness direction of the busbar forming body 130.

The first mold 210 covers the first end surface 131 on one side in the thickness direction of the plurality of busbar forming bodies 130 from the one side in the thickness direction, and the second mold 220 covers the second end surface 132 on another side in the thickness direction of the plurality of busbar forming bodies 130 from another side in the thickness direction.

As described above, in the busbar assembly 1 according to the present embodiment, the insulating resin layer 30 includes, in addition to the connecting portion 31 and the peripheral wall portion 35, the side wall portion 37 surrounding the outer side surface of the busbar connecting body 20 and the second end surface portion 39 disposed at the peripheral region of the second end surface 22 of the busbar connecting body 20 on the second side in the thickness direction.

Therefore, as shown in FIGS. 19 and 20, the mold 200 in the installation state is configured so as to define a side-wall-portion forming space 237 corresponding to the side wall portion 37 and a second-end-surface-portion forming space 239 corresponding to the second end surface portion 39, and the side-wall-portion forming space 237 and the second-end-surface-portion forming space 239 are communicated with the peripheral-wall-portion forming space 235.

As described above, in the busbar assembly 1 according to the present embodiment, the outer surface of the second-end-surface-side peripheral region 27 is positioned closer to the first side in the thickness direction than the outer surface of the second-end-surface-side center region 29 is by a distance corresponding to the thickness of the second end surface portion 39.

In order to realize the configuration, as shown in FIGS. 19 and 20, the busbar forming body 130 is configured in advance so that a region corresponding to the second-end-surface-side peripheral region 27 is thinner than a region corresponding to the second-end-surface-side center region 29 by the thickness of the second end surface portion 39 from the second end surface 132.

In the present embodiment, as shown in FIGS. 19 to 21, the peripheral-wall-portion injection hole 236 is formed in the first mold 210. However, as a matter of course, it is possible that the peripheral-wall-portion injection hole 236 is formed in the second mold 220, and it is also possible that the peripheral-wall-portion injection hole 236 is formed in both the first and second molds 210, 220.

In the present embodiment, a region of the first end surface 131 of the busbar forming body 130 where the insulating resin layer 30 is not needed is covered by a mask 240 separate from the first mold 210. However, it is possible to use a mold 200B integrally having a portion corresponding to the mask 240.

FIG. 22 shows a vertical cross-sectional view in a case where the modified mold 200B is used.

In the drawing, the same components as those in the present embodiment are given the same reference numbers.

The mold 200B according to the modified example 200B includes a first mold 310B in place of the first mold 210.

The first mold 210B integrally has a portion 240B corresponding to the mask 240 in comparison with the firs mold 210.

In the mold 200B according to the modified example, the second mold 220 is formed with a second-end-surface-side injection hole 238 communicated with the side-wall-portion forming space 237 and the second-end-surface-portion forming space 239.

As described above, in the busbar assembly 1 according to the present embodiment, the inner surface 13 of the busbar 10 includes the first-end-surface-side plate-thickness-direction extending part 13a, the plate-surface-direction extending part 13b and the second-end-surface-side plate-thickness-direction extending part 13c (see FIG. 3).

The configuration can be realized by forming the inner side surface 133 of the busbar forming body 130 into the shape corresponding to the inner side wall 13 of the busbar 10 in advance.

The injection step is configured to fill the peripheral-wall-portion forming space 235, the side-wall-portion forming space 237 and the second-end-surface-portion forming space 239 with the insulating resin material through the peripheral-wall-portion injection hole 236 and also fill the slit 125 with the insulating resin material through the connecting-portion injection hole 231.

The resin curing step is configured to perform curing process in accordance with kinds of the insulating resin material, and for example perform heat treatment.

FIG. 23 shows a vertical cross-sectional view of the mold 200 and the busbar forming body 130 after the resin curing step.

FIG. 24 shows a plan view of the busbar assembly forming region 120 after the disassembling step.

In the present embodiment, as described above, the busbar forming bodies 130 that face each other with the slit 125 interposed therebetween remain connected to each other via the connecting part 135 of the conductive metal flat plate 100 located more toward one side in the longitudinal direction of the slit 125 than the slit 125 is and the connecting part 136 of the conductive metal flat plate 100 located more toward another side in the longitudinal direction of the slit 125 than the slit 125 is.

In this case, the manufacturing method includes a step of cutting off the busbar assembly forming region 120 from the conductive metal flat plate 100 after the resin curing step and after or before the disassembling step.

As shown in FIG. 24, the cutting step includes a process of cutting the conductive metal flat plate 100 in the thickness direction along a cutting line 126 set so as to cross the slit 125 in the width direction on one side in the longitudinal direction of the slit 125 and a process of cutting the conductive metal flat plate 100 in the thickness direction along a cutting line 127 set so as to cross the slit 125 in the width direction on another side in the longitudinal direction of the slit 125.

The thus configured manufacturing method makes it possible to efficiently manufacture the busbar assembly 1 according to the present embodiment, that is, the busbar assembly 1 including the first and second busbars 10a, 10b arranged in a common plane with the gap 19 being provided therebetween, and the insulating resin layer 30 that includes the connecting portion 31 filled in the gap 19 so as to mechanically connect the first and second busbars 10a, 10b while electrically insulating them and the peripheral wall portion 35 arranged on the first end surface 21 on one side in the thickness direction of the busbar connecting body 20 in which the first and second busbars 10a, 10b is connected by the connecting portion 31, wherein the peripheral wall portion 35 is arranged at the peripheral area of the first end surface 21 of the busbar connecting body 20 so that the busbar exposed region 25 at which the first end surfaces 11 of the first and second busbars 10a, 10b are exposed is formed at a center of the busbar connecting body 20 in plain view.

That is, in the manufacturing method, the insulating resin material forming the connecting portion 31 is filled into the slit 125 between the pair of busbar forming bodies 130 and the insulating resin material forming the peripheral wall portion 35 is applied at the peripheral area of the first end surface 131 of the pair of busbar forming bodies 130 corresponding to the peripheral area of the busbar connecting body 20, while the relative position of the pair of busbar forming bodies 130 forming the first and second busbars 10a, 10b is unchanged. And then, after the insulating resin layer 30 including the connecting portion 31 and the peripheral wall portion 130 is formed by curing the insulating resin material, the pair of busbar forming bodies 130 and the insulating resin layer 30 are cut off from the conductive metal flat plate 100 to realize the busbar assembly 1.

Accordingly, the busbar assembly in which the first and second busbars 10a, 10b are mechanically connected to each other while the first and second busbars 10a, 10b being accurately arranged at a desired relative position and being reliably electrically insulated from each other and the damming structure of the sealing resin for the semiconductor element 300 such as the LDE to be mounted is efficiently manufactured.

Although the present embodiment has been explained with taking the busbar assembly 1 having two busbars inclusive of the first and second busbars 10a, 10b as an example, the present invention can be applied to a busbar assembly including three or more busbars as a matter of course.

### DESCRIPTION OF THE REFERENCE NUMERALS

- 1, 2A-2G: Busbar assembly
- 10a, 10b: First and second busbars
- 11: First end surface of busbar
- 12: Second end surface of busbar
- 13, 13F, 13G: Inner side surface of busbar
- 13a: First-end-surface-side plate-thickness-direction extending part
- 13b: Plate-surface-direction extending part
- 13c: Second-end-surface-side plate-thickness-direction extending part
- 13Da: First-end-surface-side plate-thickness-direction extending part
- 13Db: First-end-surface-side plate-surface-direction extending part
- 13Dc: Center plate-thickness-direction extending part
- 13De: Second-end-surface-side plate-surface-direction extending part
- 13Df: Second-end-surface-side plate-thickness-direction extending part
- 13Ea: first-end-surface-side inclined part
- 13Eb: Second-end-surface-side inclined part
- 15: Engagement groove
- 19: Gap
- 20: Busbar connecting body
- 21: First end surface of busbar connecting body
- 22: Second end surface of busbar connecting body
- 25: Busbar exposed region
- 27: Second-end-surface-side peripheral region
- 29: Second-end-surface-side center region
- 30: Insulating resin layer
- 31: Connecting portion
- 33: First-end-surface-side center portion
- 35: Peripheral wall portion
- 36: Stopper portion
- 37: Side wall portion
- 39: Second end surface portion
- 100: Conductive metal flat plate
- 110: Busbar assembly forming strip
- 111: First connecting strip
- 112: Second connecting strip
- 120: Busbar assembly forming region
- 125: Slit
- 130: Busbar forming body
- 140: Connecting region
- 200: Mold
- 231: Connecting-portion injection hole
- 235: Peripheral-wall-portion forming space
- 236: Peripheral-wall-portion injection hole
- 237: Side-wall-portion forming space
- 239: Second-end-surface-portion forming space

## Claims

1. A busbar assembly (1, 2A-2G) comprising a plurality of busbars (10a, 10b) formed by a conductive flat plate member and disposed in a common plane with a gap (19) being provided therebetween; and an insulating resin layer (30, 30B) including a connecting portion (31) filled in the gap (19) so as to mechanically connect the plurality of busbars (10a, 10b) while electrically insulating them and a peripheral wall portion (35) arranged on a first end surface (21) that is positioned on one side in the thickness direction of a busbar connecting body (20) in which the plurality of busbars (10a, 10b) are connected to one another by the connecting portion (31), the busbar assembly (1, 2A-2G) being **characterized in that**,
the peripheral wall portion (35) is arranged at a peripheral area of the first end surface (21) of the busbar connecting body (20) so that the busbar connecting body (20) forms at a center in plain view a busbar exposed region (25) at which the first end surfaces (11) of the plurality of busbars (10a, 10b) are exposed.

2. The busbar assembly (1, 2A, 2C-2G) according to claim 1,
wherein the insulating resin layer (30) includes a side wall portion (37) surrounding an outer side surface of the busbar connecting body (20), and a second end surface portion (39) disposed at a peripheral region of a second end surface (22) on another side in the thickness direction of the busbar connecting body (20), and
wherein the peripheral wall portion (35), the side wall portion (37) and the second end surface portion (39) are integrally formed.

3. The busbar assembly (1, 2A, 2C-2G) according to claim 2,
wherein the second end surface (22) of the busbar connecting body (20) has a second-end-surface-side peripheral region (27) at which the second end surface portion (39) is arranged, and a second-end-surface-side center region (29) surrounded by the second-end-surface-side peripheral region (27) and exposing second end surfaces (12) of the plurality of busbars (10a, 10b), and
wherein an outer surface of the second-end-surface-side peripheral region (27) is positioned closer to one side in the thickness direction than an outer surface of the second-end-surface-side center region (29) is by a distance equal to or less than a thickness of the second end surface portion (39).

4. The busbar assembly (2B) according to any one of claims 1 to 3,
wherein the plurality of busbars (10a, 10b) each are formed with engagement grooves (15) having a first end side opened to areas of the first end surfaces (11) at which the peripheral wall portion (35) is arranged,
wherein the engagement groove (15) is formed so that at least a part thereof is arranged at a position different from the first end side with respect to a plate surface direction, and
wherein the insulating resin layer (30B) includes a stopper portion (36) integrally formed with the peripheral wall portion (35) and filled into the engagement groove (15).

5. The busbar assembly (1, 2A-2C) according to any one of claims 1 to 4, wherein an inner side surface (13) out of outer surfaces of the busbar (10a) that faces the adjacent other busbar (10b) with the gap (19) being interposed therebetween includes a first-end-surface side plate-thickness-direction extending part (13a) extending from the first end surface (11) along the plate thickness direction toward another side in the thickness direction and terminating within the thickness of the busbars (10a), a plate-surface-direction extending part (13b) extending along the plate surface direction from an end of the first-end-surface side plate-thickness-direction extending part (13a) that is positioned on another side in the thickness direction toward the separating side from the other busbar (10b), and a second-end-surface-side plate-thickness-direction extending part (13c) extending along the plate thickness direction from an end of the plate-surface-direction extending part (13b) that is positioned on the separating side from the other busbar (10b) toward another side in the thickness direction and reaching the second end surface (12).

6. The busbar assembly (2C) according to claim 5,
wherein the insulating resin layer (30) includes a first-end-surface-side center portion (33) integrally formed with the connecting portion (31) and arranged on the first end surface (21) of the busbar connecting body (20), and
wherein the first-end-surface-side center portion (33) extends between a position (33a) away from an end of the first-end-surface-side plate-thickness-direction extending part (13a) that is positioned on one side in the thickness direction in one busbar (10a) of the adjacent busbars (10a, 10b) toward the separating side from the other busbar (10b) of the adjacent busbars (10a, 10b) by a predetermined distance and a position (33b) away from an end of the first-end-surface-side plate-thickness-direction extending part (13a) that is positioned on one side in the thickness direction in the other one busbar (10b) of the adjacent busbars (10a, 10b) toward the separating side from the one busbar (10a) of the adjacent busbars (10a, 10b) by a predetermined distance.

7. The busbar assembly (2D) according to any one of claims 1 to 4, wherein an inner side surface (13) out of outer surfaces of the busbar (10a) that faces the adjacent other busbar (10b) with the gap (19) being interposed therebetween includes a first-end-surface side plate-thickness-direction extending part (13Da) extending along the plate thickness direction from the first end surface (11) toward another side in the thickness direction, a first-end-surface-side plate-surface-direction extending part (13Db) extending along the plate surface direction from an end of the first-end-surface-side plate-thickness-direction extending part (13Da) that is positioned on another side in the thickness direction toward the approaching side to the adjacent other busbar (10b), a center plate-thickness-direction extending part (13Dc) extending along the plate thickness direction from an end of the first-end-surface-side plate-surface-direction extending part (13Db) that is positioned on the closer side to the other busbar (10b) toward another side in the thickness direction, a second-end-surface-side plate-surface-direction extending part (13De) extending along the plate surface direction from an end of the center plate-thickness-direction extending part (13Dc) that is positioned on another side in the thickness direction toward the separating side from the other busbar (10b), and a second-end-surface-side plate-thickness-direction extending part (13Df) extending along the plate thickness direction from an end of the second-end-surface-side plate-surface-direction extending part (13De) that is positioned on the separating side from the other busbar (10b) toward another side in the thickness direction and reaching the second end surface (12).

8. The busbar assembly (2E) according to any one of claims 1 to 4, wherein an inner side surface (13) out of outer surfaces of the busbar (10a) that faces the adjacent other busbar (10b) with the gap (19) being interposed therebetween includes a first-end-surface-side inclined part (13Ea) inclined so as to come closer to the other busbar (10b) from the first end surface (11) toward another side in the thickness direction, and a second-end-surface-side inclined part (13Eb) inclined so as to come closer to the other busbar (10b) from the second end surface (12) toward the one side in the thickness direction.

9. The busbar assembly (2F, 2G) according to any one of claims 1 to 4, wherein an inner side surface (13F, 13G) out of outer surfaces of the busbar (10a) that faces the adjacent other busbar (10b) with the gap (19) being interposed therebetween includes a portion inclined so that the gap (19) is gradually narrowed from one toward the other of the first and second end surfaces (11, 12).

10. A method for manufacturing a busbar assembly (1A, 2A-2G) including a plurality of busbars (10a, 10b) formed by a conductive flat plate member and disposed in a common plane with a gap (19) being provided therebetween; and an insulating resin layer (30, 30B) including a connecting portion (31) filled in the gap (19) so as to mechanically connect the plurality of busbars (10a, 10b) while electrically insulating them and a peripheral wall portion (35) arranged on a first end surface (21) that is positioned on one side in the thickness direction of a busbar connecting body (20) in which the plurality of busbars (10a, 10b) is connected to each other by the connecting portion (31), wherein the peripheral wall portion (35) is arranged at a peripheral area of the first end surface (21) of the busbar connecting body (20) so that a busbar exposed region (25) at which the first end surfaces (11) of the plurality of busbars (10a, 10b) are exposed is formed at a center of the busbar connecting body (20) in plain view, the method comprising:
a busbar forming body setting step of preparing a plurality of busbar forming bodies (130) that has the same material, the same shape and the same thickness as those of the plurality of busbars (10a, 10b) and arranging the plurality of busbar forming bodies (130) in the common plane with the gap (19) being provided therebetween;
a step of setting a mold (200, 200B) capable of selectively taking an installation state of surrounding the plurality of busbar forming bodies (130) so as to define a peripheral-wall-portion forming space (235) corresponding to the peripheral wall portion (35) and a disassembled state of removed from the plurality of busbar forming bodies (130), the mold (200, 200B) having a peripheral-wall-portion injection hole (236) communicated with the peripheral-wall-portion forming space (235) and a connecting-portion injection hole (231) communicated with the gap (19);
an injection step of injecting an insulating resin material that forms the peripheral wall portion (35) and the connecting portion (31) into the mold (200, 200B) through the peripheral-wall-portion injection hole (236) and the connecting-portion injection hole (231);
a resin curing step of curing the insulating resin material to form the peripheral wall portion (35) and the connecting portion (31);
a disassembling step of disassembling the mold (200); and
a taking-out step of taking out the busbar assembly (1, 2A-2G).

11. The method for manufacturing the busbar assembly (1, 2A-2G) according to claim 10,
wherein the insulating resin layer (30) includes a side wall portion (37) surrounding an outer side surface of the busbar connecting body (20) and a second end surface portion (39) disposed at a peripheral region of a second end surface (22) of the busbar connecting body (20) positioned on another side in the thickness direction,
wherein the mold (200, 200B) is configured so as to define a side-wall-portion forming space (237) corresponding to the side wall portion (37) and a second-end-surface-portion forming space (239) corresponding to the second end surface portion (39) in the installation state, and
wherein the peripheral-wall-portion forming space (235), the sidewall-portion forming space (237) and the second-end-surface-portion forming space (239) are communicated with one another.

12. The method for manufacturing the busbar assembly (1, 2A, 2C-2G) according to claim 11,
wherein the busbar forming body (130) is configured so that an area corresponding to a second-end-surface-side peripheral region (27) out of the second end surface (22) of the busbar connecting body (20) at which the second end surface portion (39) is arranged is thinner than the other area so that the second-end-surface-side peripheral region (27) is positioned closer to one side in the thickness direction than a second-end-surface-side center region (29) out of the second end surface (22) of the busbar connecting body (20) that is surrounded by the second-end-surface-side peripheral region (27) is by a distance equal to or less than a thickness of the second end surface portion (39).

13. The method for manufacturing the busbar assembly (1, 2A-2G) according to any one of claims 10 to 12,
wherein the busbar forming body setting step includes
a step of preparing a conductive metal flat plate (100) that has the same thickness as that of the busbar (10a, 10b), the conductive metal flat plate (100) including a busbar assembly forming region (120) that has the same width as that of the busbar assembly (1, 2A, 2C-2G); and
a slit forming step of forming one or a plurality of slits (125) in the busbar assembly forming region (120) that penetrates between first and second end surfaces (121, 122) on one and another side s in the thickness direction, respectively, the slit (125) having the same shape and width as those of the gap (19) to realize a state where the plurality of busbar forming bodies (130) are disposed in the common plane with the gap (19) being provided therebetween.

14. The method for manufacturing the busbar assembly (1, 2A-2G) according to claim 13,
wherein the conductive metal flat plate (100) has a plurality of the busbar assembly forming regions (120) disposed in the X direction, which is parallel to the longitudinal direction of the slit (125), in the X-Y plane where the conductive metal flat plate (100) is located, and connecting regions (140) connecting the busbar assembly forming regions (120) adjacent in the X direction, and
wherein the method further comprises a step of cutting off the busbar assembly forming region (120) from the conductive metal flat plate (100) after the resin curing step and after or before the disassembling step.

15. The method for manufacturing the busbar assembly (1, 2A-2G) according to claim 14, wherein the conductive metal flat plate (100) has a plurality of busbar assembly forming strips (110) each including the plurality of busbar assembly forming regions (120) disposed in the X direction and the connecting regions (140) connecting the busbar assembly forming regions (120) adjacent in the X direction, the plurality of busbar assembly forming strips (110) disposed in parallel in the Y direction; a first connecting strip (111) connecting the end parts on one side in the X direction of the plurality of busbar assembly forming strips (110) to one another; and a second connecting strip (112) connecting the end parts on another side in the X direction of the plurality of busbar assembly forming strips (110) to one another.
